# EUROPEAN PATENT SPECIFICATION

(11) **EP 4 525 049 B1**
(45) Date of publication and mention of the grant of the patent: **29.04.2026**
(21) Application number: 23899078.2
(22) Date of filing: 12.12.2023
(51) Int. Cl.: H10D 30/01, H10D 30/47, H10D 62/17, H10D 64/27

(54) **ENHANCED FIELD EFFECT TRANSISTOR AND MANUFACTURING METHOD THEREFOR**
VERBESSERTER FELDEFFEKTTRANSISTOR UND HERSTELLUNGSVERFAHREN DAFÜR
TRANSISTOR À EFFET DE CHAMP AMÉLIORÉ ET SON PROCÉDÉ DE FABRICATION

(30) Priority: 24.07.2023 CN 202310912208
(43) Date of publication of application: 19.03.2025
(73) Proprietor: Suzhou Institute of Nano-Tech and Nano-Bionics (SINANO), Chinese Academy of Sciences, Suzhou, Jiangsu 215123 (CN)
(72) Inventor: ZHONG, Yaozong, Suzhou Jiangsu 215123 (CN); SUN, Qian, Suzhou Jiangsu 215123 (CN); CAO, Yunzhe, Suzhou Jiangsu 215123 (CN); CHEN, Xin, Suzhou Jiangsu 215123 (CN); GUO, Xiaolu, Suzhou Jiangsu 215123 (CN); GAO, Hongwei, Suzhou Jiangsu 215123 (CN); ZHOU, Yu, Suzhou Jiangsu 215123 (CN); YANG, Hui, Suzhou Jiangsu 215123 (CN)
(74) Representative: Bayramoglu et al.
(86) International application number: PCT/CN2023/138193
(87) International publication number: WO 2025/020428

(56) References cited:
- EP-A2- 2 571 057
- CN-A- 102 386 223
- CN-A- 102 646 705
- CN-A- 105 336 789
- CN-A- 105 870 010
- CN-A- 106 206 309
- CN-A- 106 206 309
- CN-A- 113 078 212
- CN-A- 116 960 182
- US-A1- 2017 229 567
- US-A1- 2021 210 627
- US-B2- 10 680 091

## Description

This present application claims the benefit and priority of Chinese Patent Application No. 202310912208.X filed with the China National Intellectual Property Administration on July 24, 2023, and entitled "ENHANCED FIELD EFFECT TRANSISTOR AND FABRICATING METHOD THEREOF".

### TECHNICAL FIELD

The present application relates to an enhanced field effect transistor and a fabricating method thereof, in particular to a group III nitride enhanced field effect transistor and a fabricating method thereof, belonging to the technical field of semiconductor electric devices.

### BACKGROUND

Group III nitride semiconductors, known as third-generation semiconductors, have the advantages of large forbidden bandwidth, good chemical stability, high breakdown voltage and the like; moreover, high-electron-mobility transistors (HEMTs) composed of heterojunctions such as AlGaN/GaN have the advantages of high electron concentration and mobility, exhibit excellent performances in the aspects of high frequency, high voltage tolerance, low on resistance and the like, can be used as core devices in various power conversion systems, and have broad prospects in power supply applications of consumer electronics, 5G base stations, servers and the like.

Typically, in actual applications, GaN enhanced HEMT with a threshold voltage of greater than 0 V has natural advantages in the aspects of failure safety and circuit design, and therefore is more suitable for industrial transformation and commercial application. Through some gate technologies, such as a p-GaN gate, a groove gate and an ion injection gate, an energy band of a GaN channel layer can be elevated to deplete a two-dimensional electron gas (2DEG), thereby achieving the purpose of enhancement. In an actual circuit, a gate voltage is in the rapid switching process of high/low voltages, the presence of inductive load may cause a phenomenon of gate voltage oscillation overshoot to occur, and therefore a gate electrode is required to have a relatively high breakdown voltage and threshold voltage. However, high-frequency on-off actions require that the transport of carriers in a gate stack structure has synchronous high-frequency response so that a dynamic threshold voltage drift of a device is small. Hence, an actual application has extremely high requirements on performances and reliability of GaN enhanced HEMT, which is related to the industrialization of GaN HEMT or field effect transistors (FETs). At present, the p-GaN gate enhanced HEMT having technical advantages has achieved industrial transformation and commercial application.

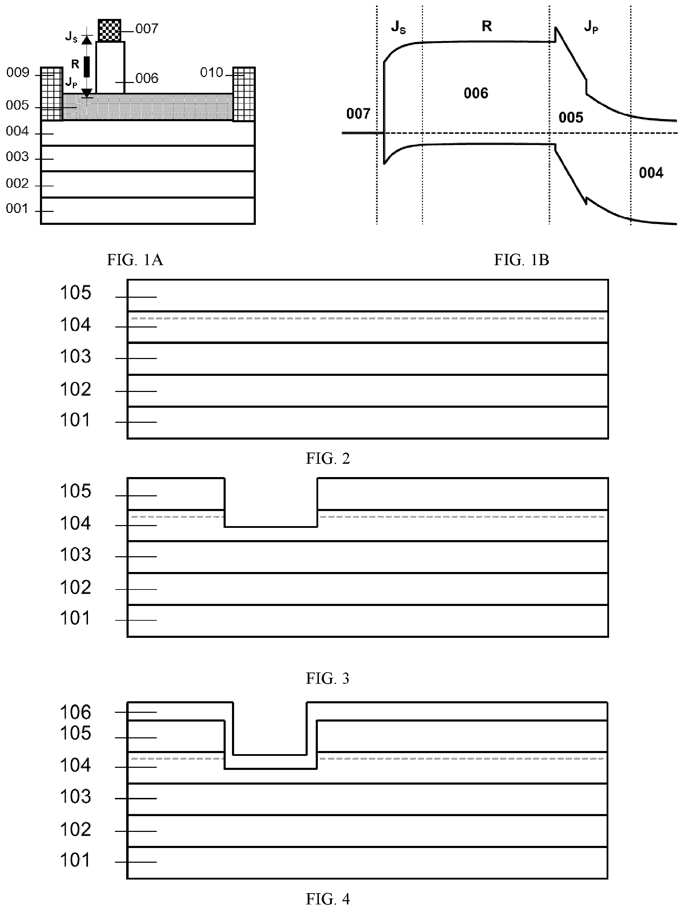

The common gate structures are "metal/p-GaN/AlGaN/GaN" stack structures, as shown in FIG. 1A. In FIG. 1A, 001 represents a substrate, 002 represents a AlN/AlGaN transition layer, 003 represents a high-resistance (Al)GaN voltage-tolerance layer, 004 represents a (Al)GaN conductive channel layer, 005 represents a AlGaN barrier layer, 006 represents a p type (Al)GaN layer, 007 represents a gate contact metal, 009 represents a source contact metal, and 010 represents a drain contact metal. The deposition of the gate metal layer is mostly performed by adopting processing methods such as evaporation and sputtering, and a work function is in a range of 4-6 eV, such as Ti, Ni and Pb. The epitaxial growth of the p-GaN/AlGaN/GaN stacked layer is mostly performed by adopting metal organic chemical vapor deposition (MOCVD), and the p-GaN layer is in a single-layer structure which is almost uniformly doped with Mg, and has a doping concentration of 1-3 × 10¹⁹/cm³ and a thickness of 70-150 nm. The AlGaN layer is in a uniform single-layer structure which has 10%-30% of Al component and a thickness of 10-30 nm, and the GaN channel layer is in a single-layer structure which has a thickness of 50-500 nm. It is noted that since the p-GaN/AlGaN/GaN stack structure of p-GaN E-HEMT fabricated by such conventional methods can typically only elevate the conduction band at an AlGaN/GaN interface by Fermi level of no more than 2 V, and therefore a threshold voltage of an actual device is relatively low, with a maximum of only 1-2 V.

As shown in FIG. 1A/B, the gate electrode of the metal/p-GaN/AlGaN/GaN stack can be equivalent to a "Schottky junction" (Jₛ) composed of metal/p-GaN and a "bilateral heterojunction PN junction" (Jₚ) composed of p-GaN/AlGaN/GaN. When the gate electrode forwardly works, the Schottky junction is in a reverse bias state, and bears most of the voltages. Since the effective acceptor concentration of the surface layer p-GaN is typically about 10¹⁹ cm⁻³, there is an extremely huge electric field in this Schottky depletion region. The tunneling, acceleration and other behaviors of carriers in the high electric field can cause the original defects in this region to be activated or form new defects, and the significantly increased defect density can lead to failure of this Schottky junction Jₛ. When dynamically turned on, an energy band barrier (typically about 0.2-0.4 eV) between p-GaN/AlGaN blocks the injection of carriers into the GaN channel, and the reversed-biased Schottky junction also blocks the entry of the carriers from the metal into p-GaN. Therefore, the carriers will be depleted or/and accumulated in the depletion region of the metal/p-GaN Schottky junction and the interface of p-GaN/AlGaN, thereby leading to gate dynamic threshold voltage drift (typically, the threshold voltage drift can be up to ± 2 V), which brings great instability to gate control.

In conclusion, the gate electrode of the existing group III nitride enhanced HEMT is mostly in a metal/p GaN/AlGaN/GaN stack structure, and the epitaxial growth of p-GaN is performed by using Mg doping and the like to provide holes for acceptors, however, it has at least the following defects:
First, the gate forward breakdown voltage in the above existing technology is low. Due to the extremely high Mg concentration (typically 10¹⁹ cm⁻³ or above) of the acceptor in p-GaN, the self-built electric field strength of the Schottky junction composed of metal/p GaN has been already very high (MV/cm magnitude). Therefore, when a positive voltage is further applied to the p-GaN gate electrode, the Schottky junction composed of metal/p-GaN is reversed-biased and the electric field is further enhanced. Under the strong electric field, extreme carrier transport behaviors such as tunneling and collision ionization are prone to occur, leading to the breakdown of the Schottky junction. The gate breakdown voltage of the conventional p-GaN E-HEMT is usually not higher than 15 V, and the normal working voltage of the gate electrode even does not exceed 6 V. Therefore, this poses a serious challenge to the gate drive of the device.

Second, the threshold voltage in the above existing technology is low. The threshold voltage of p-GaN E-HEMT is mainly determined by the p-GaN/AlGaN/GaN stack structure, and the effective acceptor Mg doping concentration, AlGaN barrier layer, Al component and other factors in p-GaN have important effects on the threshold voltage of the device. Due to the polarization effect between AlGaN/GaN, even though high Mg-doped p-GaN can only elevate the conduction band at the AlGaN/GaN interface by the Fermi level of 1-2 V. Therefore, the traditional p-GaN E-HEMT threshold voltage is usually not higher than 2 V, and the threshold voltage of the actual commercial product is mostly between 1.1 V and 1.5 V. In the actual circuit applications, voltage and current are prone to oscillation due to parasitic effects. The relatively low threshold voltage may cause devices to be mistakenly turned on, resulting in electric energy loss and even circuit damage.

Third, the dynamic threshold voltage drift in the existing technology is large. In the dynamic on-off process, since the transport behavior of gate carriers is affected by the energy band structure and defect states of the p-GaN gate electrode, the gate electrode of the traditional p-GaN E-HEMT will locally generate net positive or negative charge accumulation, resulting in a deviation of the opening voltage of 2DEG in the GaN channel from that in a static state, which is usually manifested as dynamic threshold voltage drift. Due to the low physical performance matching of the Schottky junction and the PN junction constituting p-type gates, the dynamic threshold voltage drift of the traditional p-GaN E-HEMT changes significantly with changes in working voltage, working temperature and other factors. The p-GaN gate enhanced HEMT (p-GaN E-HEMT) gradually moving towards commercial applications still has significant defects in the aspects of gate performance and reliability, restricting its entry into large-scale production and high-end market applications with high reliability requirements, which is extremely unfavorable for device applications in the fields of industrial electronics, automotive electronics and other fields with high stability and reliability requirements.

CN 106 206 309 A discloses an enhancement mode HEMT comprising a MIS-trench gate with a p-GaN semiconducotor layer located between the channel and the gate dielectric layer. CN 102 386 223 A also discloses a HEMT with a MIS-trench gate along with a p-GaN semiconductor layer situated under the gate insulator. US 2021/210627 A1 discloses an enhancement mode (e-mode) metal insulator semiconductor (MIS) high electron mobility transistor (HEMT), or EMISHEMT, with an undoped or p-doped channel regrown under a gate area. US 10 680 091 B2 discloses a semiconductor device having a heterojunction type superjunction structure. EP 2 571 057 A2 discloses normally-off semiconductor devices comprising trench gates.

### SUMMARY

The main objective of the present application is to provide an enhanced field effect transistor having a high gate forward voltage tolerance, a high threshold voltage, a low dynamic threshold voltage drift, and a fabricating method thereof, thereby overcoming the defects in the prior art.

In order to achieve the objective of the previous application, the technical solution defined by the appended claims is provided.

Compared with the prior art, the present application has the advantages:
1) the group III nitride enhanced FET provided by the present application has a higher gate forward breakdown voltage;
2) the group III nitride enhanced FET provided by the present application has a higher threshold voltage, and can meet requirements of more application scenarios on the threshold voltages of power electronic devices;
3) the group III nitride enhanced FET provided by the present application has smaller dynamic threshold voltage drift, and the device has better stability.

### BRIEF DESCRIPTION OF THE DRAWINGS

FIG. 1A is a structural diagram of a conventional enhanced HEMT;
FIG. 1B is a structural diagram of an energy band of a conventional enhanced HEMT;
FIG. 2 is a structural diagram of a depleted HEMT epitaxial structure provided in a typical embodiment of the present application (not being part of the invention);
FIG. 3 is a structural diagram of an HEMT epitaxial structure of a gate groove formed after a gate region is removed in a typical embodiment of the present application (not being part of the invention);
FIG. 4 is a structural diagram after secondary epitaxy of a p-type semiconductor layer or a unintentional Mg-doped semiconductor on the surface of an HEMT epitaxial structure in a typical embodiment of the present application (not being part of the invention);
FIG. 5 is a structural diagram of an FET after a gate dielectric layer is deposited in a typical embodiment of the present application (not being part of the invention);
FIG. 6 is a structural diagram of an FET after a source electrode/drain electrode is fabricated in a typical embodiment of the present application (not being part of the invention);
FIG. 7 is a structural diagram of an enhanced field effect transistor provided in a typical embodiment of the present application (not being part of the invention);
FIG. 8 is a structural diagram of another enhanced field effect transistor provided in a typical embodiment according to the present invention.
FIG. 9 is a structural diagram of another enhanced field effect transistor provided in a typical embodiment of the present application (not being part of the invention);
FIG. 10 is a structural diagram of another enhanced field effect transistor provided in a typical embodiment of the present application (not being part of the invention);
FIG. 11 is a structural diagram of energy bands of another enhanced field effect transistor under different gate voltages provided in a typical embodiment of the present application (not being part of the invention);
FIG. 12 is a static and dynamic transfer characteristic curve graph of another enhanced field effect transistor provided in a typical embodiment of the present application.

### DETAILED DESCRIPTION OF THE EMBODIMENTS

In view of the defects in the prior art, the inventor of this case proposes the technical solution of the present application via long-term researches and a lot of practices. Next, the technical solution, implementation process and principle of the present application will be further explained and described. The invention is summarized by the appended claims.

Next, further explanations and descriptions of the technical solution, implementation process, and principle will be further explained in conjunction with accompanying drawings and specific embodiments. Unless otherwise specified, a semiconductor epitaxial growth process and equipment thereof, photolithography and etching processes and equipment thereof, a surface repair process, annealing process and equipment thereof, a metal deposition process and equipment thereof, I-V testing equipment, and various reagents used in embodiments of the present application are all known to those skilled in the art, and specific process parameters and process equipment models are not limited herein.

Referring to FIG. 2-FIG. 7, in some specific embodiments, not falling under the scope of the invention, a fabricating method of a group III nitride enhanced field effect transistor (FET) can comprise the following steps:
1) A transition layer 102, a high-resistance voltage-tolerance layer 103, a channel layer (i.e., the previous first semiconductor layer, the same below) 104 and a barrier layer (i.e., the previous second semiconductor layer, the same below) 105 stacked are successively formed on a substrate 101 to form a depleted HEMT epitaxial wafer, as shown in FIG. 2.

Specifically, the transition layer 102 can be a AlN/AlGaN transition layer, the high-resistance voltage-tolerance layer 103 can be a high-resistance (Al)GaN voltage-tolerance layer, the channel layer 104 can be a (Al)GaN conductive channel layer, and the barrier layer 105 can be a AlGaN barrier layer.

2) The gate region of the depleted HEMT epitaxial wafer is photoetched for patterning, and then the barrier layer 105 of the gate region and a part of channel layer 104 are removed by using methods such as dry etching to form a gate groove, as shown in FIG. 3.

3) The surface of the etched depleted HEMT epitaxial wafer is treated to a certain extent (such as wet etching, thermal treatment and decomposition), and subsequently the secondary epitaxy of a p-type semiconductor layer or an unintentionally Mg-doped semiconductor layer 106 is carried out on the surface of the depleted HEMT epitaxial wafer, as shown in FIG. 4.

Specifically, the thickness of the p-type semiconductor or the unintentionally Mg-doped semiconductor layer 106 with acceptor or acceptor-like defects is 15-16 nm.

Specifically, the p-type semiconductor layer is Mg-doped, and the Mg doping concentration of the p-type semiconductor layer is less than 1×10²⁰ cm⁻³, preferably, the Mg doping concentration of the p-type semiconductor layer is 1×10¹⁵ cm⁻³-1×10²⁰ cm⁻³, preferably 5×10¹⁷ cm⁻³-1×10¹⁹ cm⁻³, for example, the Mg doping concentration of the p-type semiconductor layer is 1×10¹⁵ cm⁻³-1×10²⁰ cm⁻³, preferably 5×10¹⁷ cm⁻³-1×10¹⁹ cm⁻³; preferably, the Mg element in the p-type semiconductor layer is gradually increased from 5×10¹⁷ cm⁻³ to 5×10¹⁷ cm⁻³ along a direction deviating from the barrier layer 105, and the material of the p-type semiconductor layer comprises p-GaN, p-AlGaN, p-AlInGaN, p-InGaN, p-AlInN or p-(Al,In)GaN, and the like.

Specifically, the concentration of the acceptor or acceptor-like defects of the unintentionally doped semiconductor layer is 1×10¹⁵ cm⁻³ or above, the unintentionally doped semiconductor layer is in a high-resistivity state; preferably, the concentration of the acceptor or acceptor-like defects of the unintentionally doped semiconductor layer is 1×10¹⁵ cm⁻³-1×10²⁰ cm⁻³, preferably 5×10¹⁷ cm⁻³-1×10¹⁹ cm⁻³; further, the unintentionally Mg-doped semiconductor layer with acceptor or acceptor-like defects is in a high-resistivity state, and the material of the unintentionally Mg-doped semiconductor layer with acceptor or acceptor-like defects comprises unintentionally Mg-doped GaN, AlGaN, AlInGaN, InGaN, AlInN or (Al,In)GaN, and the like.

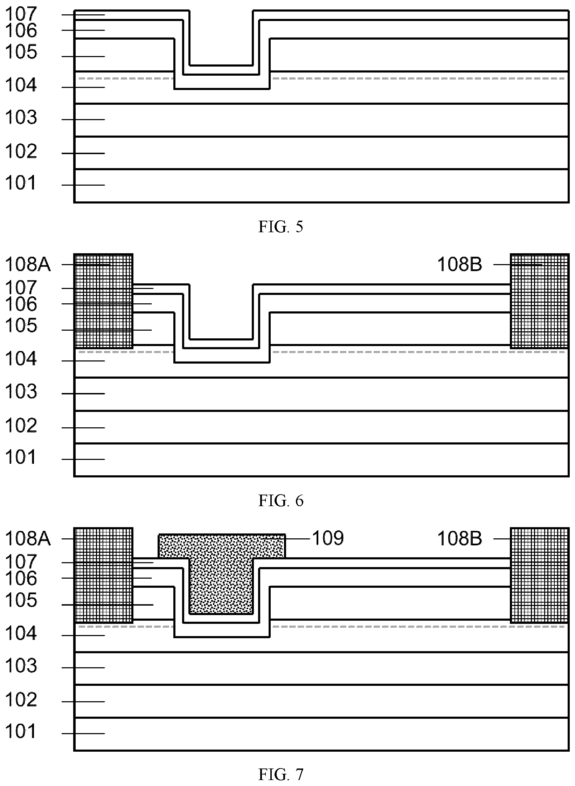

4) A gate dielectric layer 107 is deposited on the p-type semiconductor layer or the unintentionally Mg-doped semiconductor layer 106 with acceptor or acceptor-like defects, as shown in FIG. 5.

Specifically, the thickness of the gate dielectric layer 107 is 5-100 nm, and the material of the gate dielectric layer 107 comprises Al₂O₃, HfO₂, Si₃N₄ or SiO₂, or the like.

5) A source region and a drain region are etched and the channel layer 104 is exposed, stack metals are respectively deposited on the source region and the drain region, and then the stack metals are annealed to form a source electrode 108A and a drain electrode 108B, as shown in FIG. 6.

6) Gate metals are deposited on the gate dielectric layer 107 located in the gate region to form a gate electrode 109, and a MOS gate structure is formed by using the p-type semiconductor layer or unintentionally Mg-doped semiconductor layer 106, the gate dielectric layer 107 and the gate electrode 109, thereby obtaining the MOS gate FET, as shown in FIG. 7.

It is noted that the above solution can also include more subsequent device processing processes, such as deposition of interconnected metals and preparation of field board structures. In addition, the fabricating order of the source electrode 108A/drain electrode 108B and the gate electrode 109 can be changed according to the actual process, even moves to other procedures.

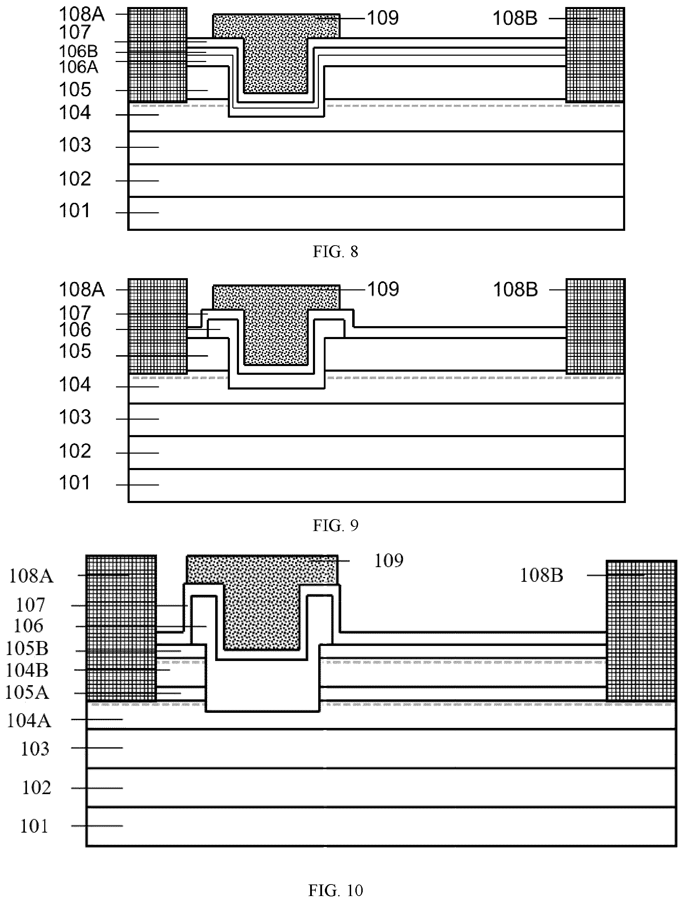

Specifically, in other specific embodiments, the secondary epitaxy of a first p-type semiconductor layer or unintentionally Mg-doped semiconductor layer 106A, a second p-type semiconductor layer or unintentionally Mg-doped semiconductor layer 106B can also be carried out in step 4, thereby forming the p-type semiconductor layer or unintentionally Mg-doped semiconductor layer. The material of the first p-type semiconductor layer or unintentionally Mg-doped semiconductor layer 106A is different from that of the second p-type semiconductor layer or unintentionally Mg-doped semiconductor layer 106B, the thickness of the first p-type semiconductor layer or unintentionally Mg-doped semiconductor layer 106A is about 10 nm, and the thickness of the second p-type semiconductor layer or unintentionally Mg-doped semiconductor layer 106B is about 5 nm. In this solution, the first p-type semiconductor layer or unintentionally Mg-doped semiconductor layer 106B, the second p-type semiconductor layer or unintentionally Mg-doped semiconductor layer 106B, the gate dielectric layer 107 and the gate electrode 109 form the MIS gate structure, and the finally obtained MIS gate FET is as shown in FIG. 8.

Specifically, in other some specific embodiments not falling under the scope of the invention, in step 4), the p-type semiconductor layer or unintentionally Mg-doped semiconductor layer 106 is only formed in the gate region, or, the p-type semiconductor layer or unintentionally Mg-doped semiconductor layer 106 in a non-gate region is removed through etching after the p-type semiconductor layer or unintentionally Mg-doped semiconductor layer 106 is formed, and the structure of the finally formed group III nitride enhanced FET is as shown in FIG. 9.

Specifically, in other some specific embodiments, not falling under the scope of the invention, in step 1), the transition layer 102, the high-resistance voltage-tolerance layer 103, the first channel layer 104A, the first barrier layer 105A, the second barrier layer 104B, the second barrier layer 105B stacked are successively formed on the substrate 101 to form the depleted HEMT epitaxial wafer, correspondingly, the groove bottom of the gate groove of the formed gate electrode is located in the first channel layer 104A; the structure of the finally formed group III nitride enhanced FET is as shown in FIG. 10.

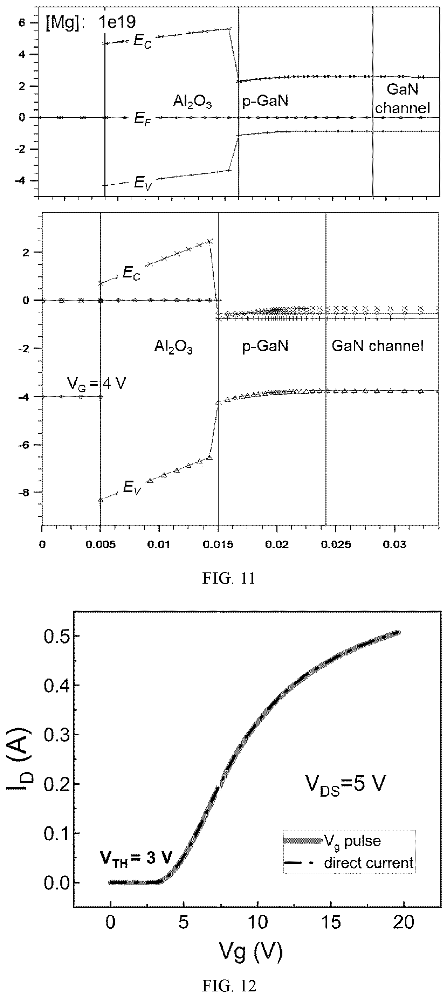

The energy band structures of this first group III nitride enhanced FET at different gate voltages are as shown in FIG. 11, the energy band structures not falling under the scope of the invention.

The present application provides a group III nitride enhanced FET which has a higher gate forward breakdown voltage. There is an electrically insulated gate dielectric layer (preferably, 5-100 nm) between the gate metal of a novel GaN enhanced FET provided by the present application and the p-type semiconductor layer or unintentionally Mg-doped semiconductor layer. Such the electrically insulated gate dielectric layer mostly adopts Al₂O₃, HfO₂ and the like formed by atomic layer deposition or Si₃N₄ or SiO₂ formed by low pressure chemical vapor deposition (LPCVD), these deposited gate dielectric layers have extremely high quality and strong breakdown electric fields and therefore can bear extremely high working voltages (20 V or above); therefore the MIS/MOS gate electrode structures fabricated by using the dielectric layers have high breakdown voltages.

The present application provides a group III nitride enhanced FET which has a higher threshold voltage. In the novel MIS/MOS gate electrode structure provided by the present application, the Fermi level of p-GaN is typically within 1.0 eV above the valence band, even pinned to the position of Mg impurity (EV+ about 0.15 eV), however, the forbidden banwidth of GaN reaches 3.4 eV, so the voltage required to force p-GaN to undergo inversion is relatively high (usually 2.5 V or above), and therefore the threshold voltage can reach 2.4-3.3 V, meeting the threshold voltage requirements for power electronic devices in multiple application scenarios.

The present application provides a group III nitride enhanced FET which has smaller dynamic threshold voltage drift. Since the inversion electrons in p-GaN are generated by field effect induction, there is no problem that the concentration of 2DEG in the channel below the traditional p-GaN E-HEMT gate electrode and the like are severely affected by gate carrier transport behaviors. In addition, since the inversion electrons are minority carriers in p-GaN, they are extremely short (ps grade) in service life, and therefore a net charge accumulation effect is also difficult to occur. Thus, in the rapid on-off process, the inversion electrons in the p-GaN channel of the gate region can rapidly response and generate small threshold voltage drift, and the device has better stability.

When the unintentionally doped semiconductor layer with acceptor or acceptor-like defects is alone used as the third semiconductor layer, the mechanism and effect of the unintentionally doped semiconductor layer with acceptor or acceptor-like defects is basically the same as that when the p-type semiconductor layer is alone used as the third semiconductor layer.

### Example 1 (not being part of the invention)

A fabricating method of a group III nitride enhanced FET comprised the following steps:
1) A depleted HEMT (D-HEMT) epitaxial wafer was grown on a substrate.

Specifically, a 600 nm AlN/AlGaN transition layer, a 4 µm C-doped Al_{0.07}Ga_{0.93}N high-resistance layer, an 300 nm high-quality low-electron-concentration unintentionally doped semiconductor layer and a 40 nm Al_{0.20}Ga_{0.80}N barrier layer were successively deposited on a Si<111> substrate by using an MOCVD method and the like to form the depleted HEMT epitaxial wafer of a AlGaN/GaN heterojunction with a two-dimensional electronic gas square resistance of 350Ω/□, a concentration of about 1.0×10¹³ cm⁻³ and a mobility of about 1800 cm²V⁻¹s⁻¹.

2) A gate groove was processed in a gate region of the depleted HEMT epitaxial wafer.

Specifically, the gate region of the depleted HEMT epitaxial wafer was patterned by using photoresist as a mask, and placed in inductively coupled plasma (ICP) etching equipment to etch off all the Al_{0.20}Ga_{0.80}N barrier layer and the about 8 nm unintentionally doped GaN layer of the gate region at a low speed, so as to form the gate groove;
the photoresist was removed by using an organic washing method such as acetone, and the depth of the gate groove was measured as 47-48 nm via test;
after residual organic matters were removed by using a piranha solution, the depleted HEMT epitaxial wafer with the grate groove was placed in tetramethylammonium hydroxide to be heated for a certain time, then transferred to a hydrofluoric acid buffered oxide etchant (BOE) to be soaked so as to remove surface oxides and surface silicon impurities.

3) An MOS gate structure, a source electrode and a drain electrode were fabricated on the depleted HEMT epitaxial wafer.

Specifically, the treated depleted HEMT epitaxial wafer was re-loaded into the MOCVD equipment and heated to 900°C along with the temperature of a furnace, the temperature was maintained for a while, then a Ga source, NH₃, N₂, Cp₂Mg and the like were introduced into the furnace, so as to perform epitaxial growth on the surface of the depleted HEMT epitaxial wafer to form a p-GaN layer, the thickness of the p-GaN layer was 15-16 nm, the concentration of Mg was gradually increased from 5×10¹⁷cm⁻³ to 1×10¹⁹ cm⁻³ along a direction deviating from the depleted HEMT epitaxial wafer;

After epitaxy was performed on the p-GaN layer, the atmosphere in the MOCVD furnace was switched to N₂, the temperature of the MOCVD furnace was adjusted to 800°C, and then maintained for a while, followed by cooling to room temperature;

The depleted HEMT epitaxial wafer was taken and placed in atom layer deposition (ALD) equipment for deposition to form a 20 nm Al₂O₃ layer on the p-GaN layer;

Then, the source region and the drain region (i.e., an ohmic region) were photoetched and patterned, the Al₂O₃ layer, the p-GaN layer and the Al_{0.20}Ga_{0.80}N barrier layer which were located in the source region and the drain region were etched off in the ICP equipment, and a layer of Ti/Al/Ti/Au=20/130/50/150 nm stack metal was deposited in the source region and the drain region, followed by rapidly annealing for 30s at the atmosphere of N₂ and at the temperature of 890°C to fabricate the source electrode and the drain electrode which were in ohmic contact;
a layer of Ti/Au=20/200 nm stack metal was deposited in the gate region followed by rapidly annealing for 60s at the atmosphere of N₂ and at the temperature of 500°C to form an MOS gate structure, thereby obtaining the MOS gate FET, as shown in FIG. 7.

I-V test was performed on the fabricated MIS gate FET. The rest results are as shown in FIG. 12, indicating that the breakdown voltage of the gate electrode reaches 22 V, the threshold voltage of the gate electrode reaches 3.1 V, and the dynamic threshold voltage drift of the gate electrode is 0.2 V. Related data are significantly increased compared with those of the traditional p-GaN E-HEMT, proving that the present application has good advantages in the aspects of gate control performance and its reliability.

### Example 2 (According to the invention)

A fabricating method of a group III nitride enhanced FET comprised the following steps:
1) A depleted HEMT (D-HEMT) epitaxial wafer was grown in a substrate.

Specifically, a 600 nm AlN/AlGaN transition layer, a 4 µm C-doped Al_{0.07}Ga_{0.93}N high-resistance layer, an 300 nm high-quality low-electron-concentration unintentionally doped GaN layer and a 45 nm Al_{0.18}Ga_{0.82}N barrier layer were successively deposited on a Si<111> substrate by using an MOCVD method to form a depleted HEMT epitaxial wafer of aAlGaN/GaN heterojunction with a two-dimensional electronic gas square resistance of 360Ω/□, a concentration of about 9.8×10¹² cm⁻³ and a mobility of about 1800 cm²V⁻¹s⁻¹.

2) A gate groove was processed in a gate region of the depleted HEMT epitaxial wafer.

Specifically, the gate region of the depleted HEMT epitaxial wafer was patterned by using photoresist as a mask, and placed in ICP etching equipment to etch off all the Al_{0.18}Ga_{0.82}N barrier layer and the about 8 nm unintentionally doped GaN layer in the gate region at a low speed, so as to form the gate groove;
the photoresist was removed by using an organic washing method such as acetone, and the depth of the gate groove was measured as 47-48 nm via test;
after residual organic matters were removed by using a piranha solution, the depleted HEMT epitaxial wafer with the grate groove was placed in tetramethylammonium hydroxide to be heated for a certain time, then transferred to a hydrofluoric acid BOE to be soaked to remove surface oxides and surface silicon impurities.

3) An MIS gate structure, a source electrode and a drain electrode were fabricated on the depleted HEMT epitaxial wafer.

Specifically, the treated depleted HEMT epitaxial wafer was re-loaded into the MOCVD equipment, heated to 900°C along the temperature of a furnace and the temperature was maintained for a while, then a Ga source, NH₃, N₂, Cp₂Mg and the like were introduced into the furnace, so as to perform epitaxial growth on the surface of the depleted HEMT epitaxial wafer to successively form an about 10 nm p-GaN layer A and an about 5 nm p-Al_{0.15}Ga_{0.85}N layer, the concentration of Mg in the p-GaN layer and the p-Al_{0.15}Ga_{0.85}N layer was gradually increased from 5×10¹⁷cm⁻³ to 1×10¹⁹ cm⁻³ along the direction deviating from the depleted HEMT epitaxial wafer.

After epitaxy was performed on the p-GaN layer and the p-Al_{0.15}Ga_{0.85}N layer, the atmosphere in the MOCVD furnace was switched to N₂, the temperature of the MOCVD furnace was maintained at 800°C for a while followed by cooling to room temperature;
the depleted HEMT epitaxial wafer was taken and placed in ALD equipment for deposition to form a 20 nm Al₂O₃ layer on the p-Al_{0.15}Ga_{0.85}N layer;
the source region and the drain region were photoetched and patterned and then placed in the ICP equipment to etch off the Al₂O₃ layer, the p-GaN layer, the p-Al_{0.15}Ga_{0.85}N layer and the Al_{0.18}Ga_{0.82}N layer which were located in the source region and the drain region, a layer of Ti/Al/Ti/Au=20/130/50/150 nm stack metal was deposited in the source region and the drain region, followed by rapidly annealing for 30s at the atmosphere of N₂ at the temperature of 890°C to fabricate the source electrode and the drain electrode which were in ohmic contact;
a layer of Ti/Au=20/200 nm stack metal was deposited in the gate region followed by rapidly annealing for 60s at the atmosphere of N₂ and at the temperature of 500°C so as to form an MIS gate structure, thereby fabricating the MIS gate FET, as shown in FIG. 8.

I-V test was performed on the fabricated GaN MOS gate FET. The rest results are as shown in FIG. 12, indicating that the breakdown voltage of the GaN MOS gate FET reaches 25 V, the threshold voltage of the GaN MOS gate FET reaches 2.8 V, and the dynamic threshold voltage drift of the GaN MOS gate FET reaches 0.08 V. Related data are significantly increased compared with those of the traditional p-GaN E-HEMT, proving that the present application has good advantages in the aspects of gate control performance and its reliability.

## Claims

1. An enhanced field effect transistor, comprising an epitaxial structure, a metal-insulator-semiconductor/metal-oxide-semiconductor (MIS/MOS) gate structure as well as a source electrode (108A) and a drain electrode (108B),
wherein the epitaxial structure comprises at least one heterojunction, the heterojunction comprises a first semiconductor layer (104) and a second semiconductor layer (105) successively stacked, a carrier channel is formed in an interface between the first semiconductor layer (104) and the second semiconductor layer (105), and the source electrode (108A) and the drain electrode (108B) are arranged in an ohmic region of the epitaxial structure and electrically connected with the carrier channel; a gate region of the epitaxial structure is provided with a gate groove, the groove bottom of the gate groove is located in the first semiconductor layer (104), the groove opening of the gate groove is located in the second semiconductor layer (105), and the carrier channel is separated by the gate groove; and
the MIS/MOS gate structure comprises a third semiconductor layer, a gate dielectric layer (107), and a gate electrode (109) successively stacked, the third semiconductor layer is at least arranged in the gate groove;
wherein the third semiconductor layer comprises a first Mg-doped, p-type semiconductor layer (106A) and a second Mg-doped, p-type semiconductor layer (106B), the first Mg-doped, p-type semiconductor layer (106A) is a 10 nm thick p-GaN layer, the second Mg doped, p-type semiconductor layer (106B) is a 5 nm thick p-Al_{0.15}Ga_{0.85}N layer, the concentration of Mg in the p-GaN layer and the p-Al_{0.15}Ga_{0.85}N layer gradually increases from 5×10¹⁷ cm⁻³ to 1×10¹⁹ cm⁻³ in a direction away from the epitaxial structure, such that the MIS/MOS gate structure has a field effect on the regulation of the carrier channel, when a forward voltage is applied to the gate electrode (109), inversion electrons generated in the third semiconductor layer stay away from the gate dielectric layer (107) and the carrier channels located at two sides of the gate electrode (109) are electrically connected via the electrons.

2. The enhanced field effect transistor according to claim 1, wherein
the third semiconductor layer is arranged in the gate region of the epitaxial structure and a region between the gate region and the ohmic region;
and/or the gate dielectric layer (107) is arranged in the gate region of the epitaxial structure and the region between the gate region and the ohmic region;
preferably, the material of the gate dielectric layer (107) comprises Al₂O₃;
preferably, the thickness of the gate dielectric layer (107) is 20 nm;
preferably, the materials of the first semiconductor layer (104) and the second semiconductor layer (105) are GaN and AlGaN respectively;
and/or the epitaxial structure also comprises a 4 µm C-doped Al_{0.07}Ga_{0.93}N layer (103) and a transition layer (102), the successively stacked heterojunctions are arranged on the C-doped Al_{0.07}Ga_{0.93}N layer (103), and the C-doped Al_{0.07}Ga_{0.93}N layer (103) is arranged on the transition layer (102); and
preferably, the transition layer (102) is a 600 nm thick AlN/AlGaN transition layer.

3. A fabricating method of an enhanced field effect transistor, comprising:
providing an epitaxial structure, which comprises at least one heterojunction comprising a first semiconductor layer (104) and a second semiconductor layer (105) successively stacked, a carrier channel being formed at an interface between the first semiconductor layer (104) and the second semiconductor layer (105);
removing all the second semiconductor layer (105) and a part of the first semiconductor layer (104) located in the gate region of the epitaxial structure, thereby forming a gate groove, the carrier channels being separated by the gate groove;
forming a third semiconductor layer, a gate dielectric layer (107), and a gate electrode (109) successively stacked at least in the gate region of the epitaxial structure, thereby forming an MIS/MOS gate structure, wherein the third semiconductor layer comprises a first Mg-doped, p-type semiconductor layer (106A) and a second Mg-doped, p-type semiconductor layer (106B), the first Mg-doped, p-type semiconductor layer (106A) is 10 nm thick p-GaN layer, the second Mg-doped, p-type semiconductor layer (106B) is 5 nm thick p-Al_{0.15}Ga_{0.85}N layer, the concentration of Mg in the p-GaN layer and the p-Al_{0.15}Ga_{0.85}N layer gradually increases from 5×10¹⁷ cm⁻³ to 1×10¹⁹ cm⁻³ in a direction away from the epitaxial structure, such that the MIS/MOS gate structure having a field effect on the regulation of the carrier channel, when a forward voltage is applied to the gate electrode (109), inversion electrons generated in the third semiconductor layer stay away from the gate dielectric layer (107) and the carrier channels located at two sides of the gate groove being electrically connected via the electrons; and
forming a source electrode (108A) and a drain electrode (108B) in the ohmic region of the epitaxial structure, the source electrode (108A) and the drain region being electrically connected with the carrier channel.

4. The fabricating method according to claim 3,
wherein the third semiconductor layer is arranged in the gate region of the epitaxial structure and a region between the gate region and the ohmic region;
and/or the gate dielectric layer (107) is arranged in the gate region of the epitaxial structure and the region between the gate region and the ohmic region;
preferably, the material of the gate dielectric layer (107) comprises Al₂O₃;
preferably, the thickness of the gate dielectric layer (107) is 20 nm;
preferably, the materials of the first semiconductor layer (104) and the second semiconductor layer (105) are GaN and AlGaN respectively.

## Patentansprüche

1. Ein verbesserter Feldeffekttransistor, bestehend aus einer Epitaxie-Struktur, einer Metall-Isolator-Halbleiter/Metall-Oxid-Halbleiter (MIS/MOS)-Gate-Struktur sowie einer Quellelektrode (108A) und einer Drain-Elektrode (108B),
wobei die Epitaxie-Struktur mindestens einen Heteroübergang umfasst, der Heteroübergang mindestens eine erste Halbleiterschicht (104) und zweite Halbleiterschicht (105) umfasst, die nacheinander gestapelt sind, ein Trägerkanal an einer Schnittstelle zwischen der ersten Halbleiterschicht (104) und der zweiten Halbleiterschicht (105) gebildet wird, und wobei die Quellelektrode (108A) und die Drain-Elektrode (108B) in einem ohmschen Bereich der Epitaxie-Struktur angeordnet und elektrisch mit dem Trägerkanal verbunden sind; ein Gate-Bereich der Epitaxie-Struktur mit einer Gate-Nut versehen ist und sich der Boden der Gate-Nut in der ersten Halbleiterschicht (104) befindet, die Nutöffnung der Gate-Nut sich in der zweiten Halbleiterschicht (105) befindet und der Trägerkanal ist durch die Gate-Nut abgetrennt ist; und
die MIS/MOS-Gate-Struktur eine dritte Halbleiterschicht, eine Gate-Dielektrikumschicht (107) und eine Gate-Elektrode (109) umfasst, die nacheinander gestapelt sind, und mindestens in der Gate-Nut angeordnet ist;
wobei die dritte Halbleiterschicht eine erste Mg-dotierte p-Halbleiterschicht (106A) und eine zweite Mg-dotierte p-Halbleiterschicht (106B) umfasst. die erste Mg-dotierte p-Halbleiterschicht (106A) ist eine 10 nm dicke p-GaN-Schicht ist, die zweite Mg-dotierte, p-leitende Halbleiterschicht (106B) eine 5 nm dicke p-Al_{0.15}Ga_{0.85}N-Schicht ist, die Konzentration von Mg in der p-GaN-Schicht und der p-Al_{0.15}Ga_{0.85}N-Schicht in Richtung von der Epitaxiestruktur weg allmählich von 5×10¹⁷ cm⁻³ auf 1×10¹⁹ cm⁻³ zunimmt, sodass die MIS/MOS-Gate-Struktur einen Feldeffekt auf die Regulierung des Trägerkanals hat, wenn eine Vorwärtsspannung an die Gate-Elektrode (109) angelegt wird, in der dritten Halbleiterschicht erzeugte Inversionselektroden von der Gate-Dielektrikumschicht (107) ferngehalten werden, und die Trägerkanäle, die sich an zwei Seiten der Gate-Elektrode (109) befinden, elektrisch über die Elektronen miteinander verbunden sind.

2. Der verbesserte Feldeffekttransistor nach Anspruch 1, wobei die dritte Halbleiterschicht im Gate-Bereich der Epitaxie-Struktur und in einem Bereich zwischen dem Gate-Bereich und dem ohmschen Bereich angeordnet ist;
und/oder die Gate-Dielektrikumsschicht (107) im Gate-Bereich der Epitaxie-Struktur und im Bereich zwischen dem Gate-Bereich und dem ohmschen Bereich angeordnet ist;
vorzugsweise das Material der Gate-Dielektrikumschicht(107) Al₂O₃ umfasst;
vorzugsweise die Dicke der Gate-Dielektrikumschicht (107) 20 nm ist;
vorzugsweise die Materialien der ersten Halbleiterschicht (104) und der zweiten Halbleiterschicht (105) GaN bzw. AlGaN sind;
und/oder die Epitaxie-Struktur auch eine 4 µm C-dotierten Al_{0.07}Ga_{0.93}N-Schicht (103) und eine Übergangsschicht (102) umfasst, die nacheinander gestapelten Heteroübergänge sind auf der C-dotierten Al_{0.07}Ga_{0.93}N-Schicht (103) angeordnet sind und die C-dotierte Al_{0.07}Ga_{0.93}N-Schicht (103) auf der Übergangsschicht (102) angeordnet ist; und
vorzugsweise die Übergangsschicht (102) eine 600 nm dicke AlN/AlGaN-Übergangsschicht ist.

3. Ein Herstellungsverfahren für einen verbesserten Feldeffekttransistor, bestehend aus:
Bereitstellung einer Epitaxie-Struktur, die mindestens einen Heteroübergang umfasst, bestehend aus einer ersten Halbleiterschicht (104) und einer zweiten Halbleiterschicht (105), die nacheinander gestapelt sind, und einem Trägerkanal, der an einer Schnittstelle zwischen der ersten Halbleiterschicht (104) und der zweite Halbleiterschicht (105) gebildet wird;
Entfernen der gesamten zweiten Halbleiterschicht (105) und eines Teiles der ersten Halbleiterschicht (104), die sich im Gate-Bereich der Epitaxie-Struktur befindet und somit eine Gate-Nut bildet, wobei die Trägerkanäle durch die Gate-Nut getrennt sind;
Bildung einer dritten Halbleitersschicht, einer Gate-Dielektrikumschicht (107) und einer Gate-Elektrode (109), die zumindest im Gate-Bereich der Epitaxie-Struktur nacheinander gestapelt sind, wodurch eine NMIS/MOS-Gate-Struktur gebildet wird, wobei die dritte Halbleiterschicht eine erste Mg-dotierte p-Halbleiterschicht (106A) und eine zweite Mg-dotierte p-Halbleiterschicht (106B) umfasst, die erste Mg-dotierte p-Halbleiterschicht (106A) eine 10 nm dicke p-GaN-Schicht ist, die zweite Mg-dotierte p-Halbleiterschicht (106B) eine 5 nm dicke p-Al_{0,15}Ga0.85N-Schicht ist, die Mg-Konzentration in der p-GaN-Schicht und der p-Al_{0.15}Ga_{0.85}N-Schicht in Richtung von der Epitaxie-Struktur weg allmählich von 5×10¹⁷ cm⁻³ auf 1×10¹⁹ cm⁻³ zunimmt, sodass die MIS/MOS-Gate-Struktur einen Feldeffekt auf die Regulierung des Trägerkanals ausübt, wenn eine Vorwärtsspannung an die Gate-Elektrode (109) angelegt wird, in der dritten Halbleiterschicht erzeugte Inversionselektroden von der Gate-Dielektrikumschicht (107) ferngehalten werden, und die Trägerkanäle, die sich an zwei Seiten der Gate-Elektrode (109) befinden, elektrisch über die Elektronen miteinander verbunden sind; und
Bildung einer Quellelektrode (108A) und einer Drain-Elektrode (108B) im ohmschen Bereich der Epitaxie-Struktur, wobei die Quellelektrode (108A) und der Drain-Bereich elektrisch mit dem Trägerkanal verbunden sind.

4. Das Herstellungsverfahren nach Anspruch 3, wobei die dritte Halbleiterschicht ist im Gate-Bereich der Epitaxie-Struktur und einem Bereich zwischen dem Gate-Bereich und dem ohmschen Bereich angeordnet ist;
und/oder die Gate-Dielektrikumsschicht (107) im Gate-Bereich der Epitaxie-Struktur und im Bereich zwischen dem Gate-Bereich und dem ohmscher Bereich angeordnet ist;
vorzugsweise das Material der Gate-Dielektrikumschicht (107) Al₂O₃ umfasst;
vorzugsweise die Dicke der Gate-Dielektrikumschicht (107) 20 nm ist;
vorzugsweise die Materialien der ersten Halbleiterschicht (104) und der zweiten Halbleiterschicht (105) GaN bzw. AlGaN sind.

## Revendications

1. Un transistor à effet de champ amélioré, comprenant une structure épitaxiale, une structure de grille métal-isolant-semi-conducteur/métal-oxyde métallique (MIS/MOS) ainsi qu'une électrode source (108A) et une électrode de drain (108B),
dans lequel la structure épitaxiale comprend au moins une hétérojonction, l'hétérojonction comprend une première couche semi-conductrice (104) et une seconde couche semi-conductrice (105) empilées successivement, un canal porteur est formé à une interface entre la première couche semi-conductrice (104) et la seconde couche semi-conductrice (105), et l'électrode source (108A) et l'électrode de drain (108B) sont disposées dans une région ohmique de la structure épitaxiale et connectées électriquement au canal porteur ; une région de grille de la structure épitaxiale est dotée d'une rainure de grille, le fond de la rainure de grille est situé dans la première couche semi-conductrice (104), l'ouverture de la rainure de la rainure de grille est située dans la deuxième couche semi-conductrice (105), et le canal porteur est séparé par la rainure de grille ; et
la structure de grille MIS/MOS comprend une troisième couche semi-conductrice, une couche diélectrique de grille (107) et une électrode de grille (109) empilées successivement, la troisième couche semi-conductrice étant au moins disposée dans la rainure de grille ;
dans lequel la troisième couche semi-conductrice comprend une première couche semi-conductrice de type p dopée au Mg (106A) et une seconde couche semi-conductrice de type p dopée au Mg (106B), la première couche semi-conductrice de type p dopée au Mg (106A) est une couche p-GaN de 10 nm d'épaisseur, la deuxième couche semi-conductrice de type p dopée au Mg (106B) est une couche p-Al_{0,15}Ga_{0,85}N d'épaisseur de 5 nm, la concentration de Mg dans la couche p-GaN et la couche p-Al_{0,15Ga0,85}N augmente progressivement de 5×10¹⁷cm⁻³ à 1×10¹⁹ cm⁻³ dans une direction éloignée de la structure épitaxiale, de sorte que la structure de grille MIS/MOS ait un effet de champ sur la régulation du canal porteur, lorsqu'une tension directe est appliquée à l'électrode de grille (109), les électrons d'inversion générés dans la troisième couche semi-conductrice s'éloignent de la couche diélectrique de grille (107) et les canaux porteurs situés de chaque côté de l'électrode de grille (109) sont connectés électriquement via les électrons.

2. Le transistor à effet de champ amélioré selon la revendication 1, dans lequel la troisième couche semi-conductrice est disposée dans la région de grille de la structure épitaxiale et une région entre la région de grille et la région ohmique ;
et/ou la couche diélectrique de grille (107) est disposée dans la région de grille de la structure épitaxiale et la région entre la région de grille et la région ohmique ;
de préférence, le matériau de la couche diélectrique de grille (107) comprend Al₂O₃ ;
de préférence, l'épaisseur de la couche diélectrique de grille (107) est de 20 nm ;
de préférence, les matériaux de la première couche semi-conductrice (104) et de la seconde couche semi-conductrice (105) sont respectivement GaN et AlGaN ;
et/ou la structure épitaxiale comprend également une couche Al_{0.07}Ga_{0.93}N dopée à C de 4 µm (103) et une couche de transition (102), les hétérojonctions successivement empilées sont disposées sur la couche Al_{0.07}Ga_{0.93}N dopée à C (103), et la couche Al_{0.07}Ga_{0.93}N dopée à C (103) est disposée sur la couche de transition (102) ; et
de préférence, la couche de transition (102) est une couche de transition AlN/AlGaN de 600 nm d'épaisseur.

3. Procédé de fabrication d'un transistor à effet de champ amélioré, comprenant :
fourniture d'une structure épitaxiale, qui comprend au moins une hétérojonction comprenant une première couche semi-conductrice (104) et une seconde couche semi-conductrice (105) empilées successivement, un canal porteur étant formé à l'interface entre la première couche semi-conductrice (104) et la seconde couche semi-conductrice (105) ;
retrait de toute la deuxième couche semi-conductrice (105) et d'une partie de la première couche semi-conductrice (104) située dans la région de grille de la structure épitaxiale, formant ainsi une rainure de grille, les canaux porteurs étant séparés par la rainure de grille ;
formation d'une troisième couche semi-conductrice, une couche diélectrique de grille (107) et une électrode de grille (109) empilées successivement au moins dans la région de grille de la structure épitaxiale, formant ainsi une structure de grille MIS/MOS, dans lequel la troisième couche semi-conductrice comprend une première couche semi-conductrice de type p dopée au Mg (106A) et une deuxième couche semi-conductrice de type p dopée au Mg (106B), la première couche semi-conductrice de type p dopée au Mg (106A) est une couche p-GaN de 10 nm d'épaisseur, la seconde couche semi-conductrice de type p dopée au Mg (106B) est une couche p-Al_{0,15}Ga_{0,85}N de 5 nm d'épaisseur, la concentration de Mg dans la couche p-GaN et la couche p-Al _{0,15}Ga_{0,85}N augmente progressivement de 5×10¹⁷ cm⁻³ à 1×10¹⁹ cm⁻³ dans une direction éloignée de la structure épitaxiale, de sorte que la structure de grille MIS/MOS a un effet de champ sur la régulation du canal porteur, lorsqu'une tension directe est appliquée à l'électrode de grille (109), les électrons d'inversion générés dans la troisième couche semi-conductrice s'éloignent de la couche diélectrique de grille (107) et des canaux porteurs situés de deux côtés de la rainure de grille connectés électriquement via les électrons ; et
formation d'une électrode source (108A) et une électrode de drain (108B) dans la région ohmique de la structure épitaxiale, l'électrode source (108A) et la région de drain étant connectées électriquement au canal porteur.

4. Procédé de fabrication selon la revendication 3, dans lequel la troisième couche semi-conductrice est disposée dans la région de grille de la structure épitaxiale et une région entre la région de grille et la région ohmique ;
et/ou la couche diélectrique de grille (107) est disposée dans la région de grille de la structure épitaxiale et la région entre la région de grille et la région ohmique ;
de préférence, le matériau de la couche diélectrique de grille (107) comprend Al₂O₃ ;
de préférence, l'épaisseur de la couche diélectrique de grille (107) est de 20 nm ;
de préférence, les matériaux de la première couche semi-conductrice (104) et de la deuxième couche semi-conductrice (105) sont respectivement GaN et AlGaN.
